Europäisches Patentamt

European Patent Office

Office européen des brevets

(11) Publication number: **0 084 859**
**B1**

(12) **EUROPEAN PATENT SPECIFICATION**

(45) Date of publication of patent specification: **21.09.88**

(51) Int. Cl.⁴: **H 01 L 23/30, H 01 L 23/48**

(21) Application number: **83100477.5**

(22) Date of filing: **20.01.83**

(54) **Glass-molded semiconductor device.**

(30) Priority: **27.01.82 JP 10122/82**

(43) Date of publication of application:
**03.08.83 Bulletin 83/31**

(45) Publication of the grant of the patent:
**21.09.88 Bulletin 88/38**

(84) Designated Contracting States:
**DE FR GB**

(56) References cited:
**FR-A-2 387 498**
**JP-A-50 028 273**
**US-A-4 153 910**

(73) Proprietor: **Hitachi, Ltd.**
**5-1, Marunouchi 1-chome**
**Chiyoda-ku Tokyo 100 (JP)**

(72) Inventor: **Hachino, Hiroaki**
**2-26-18, Moriyama-cho**
**Hitachi-shi Ibaraki-ken (JP)**
Inventor: **Misawa, Yutaka**
**818-6, Tabiko**
**Katsuta-shi Ibaraki-ken (JP)**
Inventor: **Ishizuka, Takeshi**
**3-14-29, Higashinarusawa-cho**
**Hitachi-shi Ibaraki-ken (JP)**

(74) Representative: **Patentanwälte Beetz sen. -**
**Beetz jun. Timpe - Siegfried - Schmitt-Fumian**
**Steinsdorfstrasse 10**
**D-8000 München 22 (DE)**

Courier Press, Leamington Spa, England.

## Description

Background of the invention

Field of the invention

The present invention relates to a semiconductor device and more particularly to an arrangement of electrode leads of an axial-lead glass-molded semiconductor device.

Description of the prior art

The axial-lead glass-molded semiconductor device of the type mentioned above is arranged such that at least one semiconductor element is brazed between electrodes of a pair of electrode leads each having an electrode provided at one end of a lead, and the semiconductor element is covered with glass extending over from one of the electrodes to the other by means of molding, while the lead electrodes and the semiconductor element are placed on a straight line.

In general, the molding glass must have a function to stabilize the surface of the semiconductor element. Moreover, since the electrodes and the molding glass are directly connected together and the electrodes and the semiconductor element are brazed, it is necessary for the members to have thermal expansion coefficients approximate to each other.

Therefore, there is conventionally a serious restriction on selection of materials for the electrodes and the molding glass.

As the electrodes, molybdenum, tungsten or iron-nickel alloy is hitherto employed, and a lead of copper or an alloy having copper as a principal component is welded to each electrode to form an electrode lead. The electrode lead of this type undesirably has not only a low humidity resistance at the welded part but also poor thermal and electrical conductivities.

Although such an electrode lead has been proposed as having a cylinder of molybdenum, tungsten, or iron-nickel alloy fitted on the end part of a copper lead (JP—A—50 28273), the electrode lead of this type has a difficulty in fitting the cylinder on the lead end, together with a problem that an external stress applied on the lead is directly transmitted to the semiconductor element.

Another electrode lead has been described as having a copper lead to one end of which is welded a stopper formed of e.g. a ferro-alloy having a larger diameter than the copper lead, to which stopper a silicon pellet is to be soldered (US—A—41 53 910).

Summary of the invention

It is an object of the present invention to provide a glass-molded semiconductor device having an enlarged freedom degree in selection of materials.

Another object of the present invention is to provide a glass-molded semiconductor device higher in thermal and electrical conductivities between the electrode leads and the semiconductor element.

Still another object of the present invention is to provide a glass-molded semiconductor device excellent in humidity resistance and stress resistance.

To these ends, according to the present invention, there is provided a glass-molded semiconductor device comprising a pair of electrode leads having electrodes at one ends of leads, respectively; at least one semiconductor element brazed between said electrodes; and glass provided extending over from one of said electrodes to the other so as to cover said semiconductor element by means of molding, wherein said lead is made of a material excellent in thermal and electrical conductivities, while each of said electrodes is composed of a core material of the same kind as said material for said lead and a tubular material provided on the outer periphery of said core material and having a thermal expansion coefficient lower than that of said lead which is in mechanical and electrical contact with said core material, characterized in that the leads are in electrical and mechanical contact with said core material by welding, that said core material and said tubular material are metallurgically connected together by means of wire-drawing cladding, and that the thickness of said tubular material is determined such that the thermal expansion coefficient of the electrode in the longitudinal direction is adapted to the thermal expansion coefficient of the molding glass.

Brief description of the drawings

Fig. 1 is a longitudinal sectional view of an axial-lead glass-molded semiconductor device in accordance with a preferred embodiment of the present invention;

Fig. 2 is an enlarged sectional view of an electrode lead employed in the axial-lead glass-molded semiconductor device shown in Fig. 1; and

Fig. 3 is a longitudinal sectional view of an axial-lead glass-molded high-voltage diode in accordance with another preferred embodiment of the present invention.

Description of the preferred embodiments

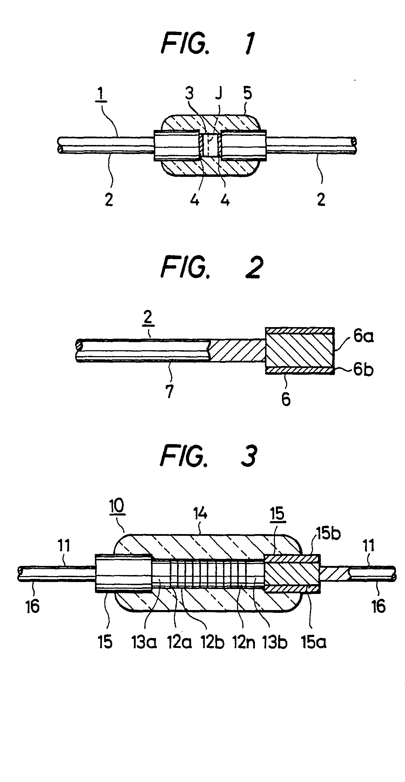

Referring to Fig. 1, an axial-lead glass-molded diode in accordance with a preferred embodiment of the present invention comprises electrode leads 2, a semiconductor element 3, brazing material (solder) 4 and molding glass 5. Each of the electrode leads 2 comprises an electrode 6 composed of a core material 6a and a tubular material 6b, and a lead 7, as shown in Fig. 2.

The axial-lead glass-molded diode will be described hereinunder in greater detail with reference to the Figures.

The silicon semiconductor element 3 has a pn junction J exposed on the side peripheral surface thereof and the electrodes 6 brazed to the main surfaces thereof by means of the brazing material 4, such as soft solder or hard solder, e.g., a silver solder or an aluminum solder. In other words, the semiconductor element 3 is brazed being clamped between the electrodes 6 facing each other. The molding glass 5 is provided over from one electrode 6 to the other electrode 6 by sintering slurry glass, for example. As the molding glass 5, glass having a function to stabilize the surface of the semiconductor element 3 is employed, for example, a $ZnO{-}B_2O_3{-}SiO_2$ glass or a $PbO{-}B_2O_3{-}SiO_2$ glass.

As the core material 6a and the lead 7, copper or an alloy having copper as a principal component is employed, while as the tubular material 6b, an iron-nickel alloy is employed.

It is preferable to employ the same kind of alloy for the core material 6a and the lead 7, and the alloy should be excellent in thermal and electrical conductivities. The tubular material 6b has a thermal expansion coefficient lower than that of the core material 6a. Moreover, it is preferable that the core material 6a should have a larger diameter than the lead 7.

The core material 6a and the tubular material 6b are metallurgically connected together by means of wire-drawing cladding. The electrode 6 is obtained by cutting the core material 6a connected with the tubular material 6b into a predetermined length after the wire drawing. Accordingly, after the electrode 6 is formed, the lead 7 is welded to the core material 6a.

The actions and effects of the semiconductor device in accordance with the present invention will be described hereinunder.

As a first effect, the freedom degree in selection of each member is enlarged, so that it is possible to obtain a semiconductor device with excellent characteristics.

The thermal expansion coefficient of the electrode 6 in the longitudinal direction can be regulated at will by varying the thickness of the tubular material 6b.

This will be described hereinunder with an example wherein copper was employed as the core material 6a, while an invar alloy (iron—36% nickel alloy) was employed as the tubular material 6b. As described above, the electrode 6 is formed by a conventional clad wire manufacturing method by means of wire drawing, and the core material 6a and the tubular material 6b is metallurgically connected together.

The Table below shows the actual measurements of the thermal expansion coefficient $\alpha_l$ of the electrode 6 in the longitudinal direction obtained when the thickness B of the tubular material 6b is varied with respect to the diameter A of the core material 6a.

TABLE 1

| No. | A (mm) | B (mm) | $\alpha_l$ (/°C) |
|---|---|---|---|
| 1 | 1 | 0.1 | $11.8 \times 10^{-6}$ |
| 2 | 1 | 0.2 | $8.5 \times 10^{-6}$ |
| 3 | 1 | 0.3 | $6.9 \times 10^{-6}$ |
| 4 | 1 | 0.4 | $5.7 \times 10^{-6}$ |
| 5 | 1 | 0.5 | $4.9 \times 10^{-6}$ |

As apparent from the Table above, the thermal expansion coefficient $\alpha_l$ of the electrode 6 in the longitudinal direction can be regulated at will by varying the thickness B of the tubular material 6b. On the other hand, the thermal expansion coefficient $\alpha_R$ of the electrode 6 in the radial direction is determined by the thermal expansion coefficient of the tubular material 6b and was substantially equal to the thermal expansion coefficient of the semiconductor element 3.

Therefore, it is obvious from the above that it is only necessary to determine the thickness of the tubular material 6b of the electrode 6 in consideration of the thermal expansion coefficient of the molding glass 5 having a composition determined so as to satisfy the required various characteristics such as a function to stabilize the surface. Accordingly, the thermal expansion coefficient conventionally important as a material selection factor can be eliminated in the present invention, so that it becomes possible to enlarge the freedom degree in selection of materials.

Consequently, since each member of the semiconductor device 1 can employ a material satisfying the required characteristics without being restricted by other members, mechanical and electrical characteristics are greatly improved, so that it is possible to obtain a semiconductor device with a higher reliability.

In this connection, an examination was made on an electrode lead formed simply by mechanically fitting an invar alloy on the end of a lead wire according to the prior art. As a result, the thermal expansion

3

**0 084 859**

coefficient of the electrode portion in the longitudinal direction was governed by the thermal expansion coefficient of the invar alloy itself and hardly changed even by varying the thickness thereof, so that it was impossible to obtain a highly reliable semiconductor device.

Since glass having a thermal expansion coefficient of about 5 to $10\times10^{-6}/°C$ is conventionally employed as the molding glass 5, if the thermal expansion coefficient of the electrode is desired to match with this thermal expansion coefficient, the ratio of the thickness B of the tubular material 6b with respect to the diameter A of the core material 6a should be 0.2 to 0.5 according to the present invention.

A second effect is that it is possible to obtain a semiconductor device extremely excellent in thermal and electrical conductivities.

This effect can be obtained owing to the fact that it is possible to employ materials excellent in thermal and electrical conductivities, since the core material 6a and the lead 7 directly contact each other and moreover the thermal expansion coefficient of the electrode is determined by the tubular material 6b.

Comparison was made between a conventional semiconductor device employing as the electrode 6 molybdenum or tungsten as it was and the semiconductor device according to the present invention with their dimensions made equal to each other. As a result, the thermal resistance between the pn junction J of the semiconductor element 3 and the outside air of the semiconductor device according to the invention is about 15% lower than that of the conventional one. Therefore, it was confirmed that the semiconductor device according to the invention is more excellent in thermal conductivity. Moreover, it was confirmed that the semiconductor device according to the invention is more excellent also in electrical conductivity.

A third effect is that it is possible to obtain a semiconductor device excellent in humidity resistance.

Since the electrode lead 6 according to the present invention is composed of the core material 6a and the tubular material 6b which are metallurgically connected together by means of cladding, the outside air, particularly moisture cannot reach the semiconductor element 3.

Moreover, since the core material 6a and the lead 7 are made of the same kind of metal, they firmly connect together. In particular, in the case where the diameter of the core material 6a is made larger than that of the lead 7, even if there is a little scattering in positioning both of them, the lead 7 has little chance of contacting the tubular material 6b. Accordingly, there is no possibility of connection between metals of different kinds.

If there is a gap at the connection between the electrode 6 and the lead 7, moisture enters the gap, corroding both of them, and this phenomenon develops. In addition, since an external stress is applied to the lead 7 in use, the gap enlarges, and finally, the electrode 6 and the lead 7 are separated from each other. According to the invention, since the core material 6a and the lead 7 are connected together without any gap, the semiconductor device is strong against moisture and excellent in humidity resistance.

Moreover, since when an iron-nickel alloy is employed as the tubular material 6b, since the alloy is excellent in wetting property, the molded interface has no gap. Therefore, there is no possibility that the outside air may invade therefrom, so that it is possible to obtain a semiconductor device excellent in humidity resistance.

A fourth effect is that it is possible to obtain a semiconductor device excellent in stress resistance.

The external stress applied to the lead 7 is attenuated and absorbed by the part thereof welded to the core material 6a. Accordingly, the semiconductor element 3 and the glass 5 are hardly in danger of directly receiving an external stress, so that it is possible to obtain a semiconductor device excellent in stress resistance.

A fifth effect is that the manufacture of semiconductor devices is facilitated.

Since the core material 6a and the tubular material 6b are easily metallurgically connected together by means of cladding technique, and since the core material 6a and the lead 7 can be easily welded together by employing metals of the same kind, it is possible to easily obtain the electrode lead 6 having the above-mentioned first to fourth effects.

It is to be noted that it is not always necessary that the core material 6a and the lead 7 have completely the same composition, and it is possible to obtain effects similar to those mentioned above by employing materials having identical principal components, for example, copper for the core material 6a and copper containing zircon for the lead 7. It is to be understood in this sense that the core material 6a and the lead 7 are made of materials of the same kind in the present invention.

A practical example of the invention will be described hereinunder.

First, a clad wire of copper with a diameter of 1 mm and having an invar alloy provided on the outer periphery thereof and having a thickness of 0.3 mm was prepared by employing the known wire-drawing cladding technique and then cut into a chip having a length of 2 mm. This chip, to be the electrode 6, was immersed in dilute nitric acid for several seconds for washing. Projections at the cut portion generally called "burr" were removed by this operation. Then, the chip was immersed in acetone for washing and left as it was for drying to obtain a clean electrode 6.

A copper wire having a diameter of 0.8 mm was welded to the core material 6a of this electrode 6 and cut into a length of 30 mm to obtain an electrode lead 2 as the lead 7.

Then, the silicon diode pellet (semiconductor element) 3 having a diameter of about 1.2 mm was brazed between a pair of electrode leads 2 by means of aluminum solder 4 as shown in Fig. 1. Finally, as the molding glass 5 a $ZnO-B_2O_3-SiO_2$ glass was sintered to obtain an axial-lead glass-molded diode.

It is to be noted that although one silicon diode pellet is employed in the above embodiment, the

4

present invention is well applicable to a high-voltage diode having a plurality of diode pellets laminated and bonded between a pair of electrode leads 2.

Referring to Fig. 3 showing a high-voltage diode to which the present invention is applied, between a pair of electrode leads 11, a plurality of diode pellets 12a, 12b ... 12n having pn junctions are laminated in the same predetermined rectification direction and bonded by means of a brazing material, not shown, through spacers 13a, 13b having no pn junctions. A molding glass 14 is a $ZnO-B_2O_3-SiO_2$ glass, for example. Since the electrode leads 11 have the same arrangement, only one of them will be described hereinunder. An electrode 15 comprises a core material 15a and a tubular material 15b, which are metallurgically connected together similarly to the electrode lead 2 shown in Fig. 2. As the core material 15a, copper, which is excellent in thermal and electrical conductivities, is employed, while as the tubular material 15b an invar alloy is employed having a thermal expansion coefficient smaller than that of the copper as the core material. The core material 15a and the tubular material 15b are metallurgically connected together by employing a wire-drawing cladding technique. A lead 16 made of a material of the same kind as the core material 15a is welded to the core material 15a. Silicon is employed as the diode pellets 12a, 12b ... 12n and the spacers 13a, 13b. The brazing material is aluminum, for example.

In the diode of this type, as the number of lamination of the diode pellets 12a, 12b ... 12n increases, it becomes impossible to neglect the thermal expansion amount of the brazing material employed for bonding the same. Therefore, it is necessary to allow the thermal expansion coefficients of the molding glass, the diode pellet laminate and the electrode to match with each other by, for example, providing spacers as presented in US—A—3913127.

According to the present invention, however, since the thermal expansion coefficient of the electrode 15 in the longitudinal direction can be regulated at will, it is possible to obtain a glass-molded high-voltage diode having the above-mentioned first to fifth effects by employing the molding glass and the electrode having thermal expansion coefficients matching with that of the diode pellet laminate including the spacers 13a, 13b.

It is to be noted that there is no need for regulation in thickness of the spacers 13a, 13b for matching the thermal expansion coefficients with each other according to US—A—3913127, and the spacers 13a, 13b are provided with a thickness only for preventing the characteristics of the diode pellets 12a, 12n at both ends from being deteriorated by air bubbles in the molding glass 14 generated at the step portion between the electrode 15 and the diode pellet laminate.

## Claims

1. A glass-molded semiconductor device comprising: a pair of electrode leads (2) having electrodes (6) at one ends of leads (7), respectively; at least one semiconductor element (3) brazed between said electrodes (6); and glass (5) providing extending over from one of said electrodes (6) to the other so as to cover said semiconductor element (3) by means of molding, wherein said lead (7) is made of a material excellent in thermal and electrical conductivities, while each of said electrodes (6) is composed of a core material (6a) of the same kind as said material for said lead (7) and a tubular material (6b) provided on the outer periphery of said core material (6a) and having a thermal expansion coefficient lower than that of said lead (7), which is in mechanical and electrical contact with said core material (6a), characterized in that the leads (7) are in electrical and mechanical contact with said core material (6a) by welding, that said core material (6a) and said tubular material (6b) are metallurgically connected together by means of wire-drawing cladding, and that the thickness of said tubular material (6b) is determined such that the thermal expansion coefficient of the electrode (6) in the longitudinal direction is adapted to the thermal expansion coefficient of the molding glass (5).

2. A glass-molded semiconductor device as defined in claim 1, wherein said core material (6a) has a diameter larger than that of said lead (7).

3. A glass-molded semiconductor device as defined in claim 1, wherein said lead (7) is made of either copper or a material having copper as a principal component, while said tubular material (6b) is made of an iron-nickel alloy.

## Patentansprüche

1. Glasverkapselte Halbleitervorrichtung, umfassend: ein Paar Elektrodenanschlüsse (2), die eine Elektrode (6) an einem Ende jeder Zuleitung (7) aufweisen; wenigstens ein zwischen den Elektroden (6) hartverlötetes Halbleiterelement (3); und Glas (5), das durch Vergießen von der einen zur anderen Elektrode (6) verlaufend das Halbleiterelement (3) überdeckend vorgesehen ist, wobei die Zuleitung (7) aus einem Werkstoff mit sehr guter thermischer und elektrischer Leitfähigkeit besteht, während jede Elektrode (6) aus einem Kern (6a) aus dem gleichen Werkstoff wie der Werkstoff für die Zuleitung (7) und einem rohrförmigen Werkstoff (6b) besteht, der auf der Außenseite des Kernmaterials (6a) angeordnet ist und dessen Wärmedehnzahl niedriger als diejenige der Zuleitung (7) ist und der mit dem Kern (6a) in mechanischem und elektrischem Kontakt steht, dadurch gekennzeichnet, daß die Zuleitungen (7) durch Verschweißen den Kernwerkstoff (6a) elektrisch und mechanisch kontaktieren, daß der Kernwerkstoff (6a) und der rohrförmige Werkstoff (6b) metallurgisch durch Drahtziehummanteln miteinander verbunden sind, und daß die Dicke des rohrförmigen Werkstoffs (6b) so bestimmt ist, daß die Wärmedehnzahl der Elektrode (6) in Längsrichtung an die Wärmedehnzahl des Verkapselungsglases (5) angepaßt ist.

2. Glasverkapselte Halbleitervorrichtung nach Anspruch 1, wobei der Kernwerkstoff (6a) einen größeren Durchmesser als die Zuleitung (7) hat.

3. Glasverkapselte Halbleitervorrichtung nach Anspruch 1, wobei die Zuleitung (7) entweder aus Kupfer oder einem Werkstoff mit Kupfer als Hauptbestandteil besteht, während der rohrförmige Werkstoff (6) aus einer Eisen-Nickel-Legierung besteht.

**Revendications**

1. Dispositif à semiconducteurs enrobé de verre, comprenant: un couple de fils à électrodes (2) comportant des électrodes (6) situées respectivement au niveau d'une extrémité des fils (7); au moins un élément semiconducteur (3) fixé par brasage entre lesdites électrodes (6); et un verre (5) disposé de manière à s'étendre au-dessus de l'une desdites électrodes (6) en direction de l'autre électrode de manière à recouvrir ledit élément semiconducteur (3) sous la forme d'un enrobage, et dans lequel ledit fil (7) est réalisé en un matériau présentant une excellente conductibilité thermique et une excellente conductibilité électrique, tandis que chacune desdites électrodes (6) est constituée par un matériau (6a) formant noyau, du même type que ledit matériau prévu pour ledit fil (17), et par un matériau tubulaire (6b) prévu sur le pourtour extérieur dudit matériau formant noyau (6a) et possédant un coefficient de dilatation thermique inférieur à celui dudit fil (7), qui est en contact mécanique et électrique avec ledit matériau formant noyau (6a), caractérisé en ce que les fils (7) sont en contact électrique et mécanique avec ledit matériau formant noyau (6a), par soudage, que ledit matériau formant noyau (6a) et ledit matériau tubulaire (6b) sont raccordés par voie métallurgique l'un à l'autre au moyen d'un tréfilage-gainage, et que l'épaisseur dudit matériau tubulaire (6b) est déterminée de telle sorte que le coefficient de dilatation thermique de l'électrode (6) dans la direction longitudinale est adapté au coefficient de dilatation thermique du verre d'enrobage (5).

2. Dispositif à semiconducteurs enrobé de verre selon la revendication 1, dans lequel ledit matériau formant noyau (6a) possède un diamètre supérieur à celui dudit fil (7).

3. Dispositif à semiconducteurs enrobé de verre selon la revendication 1, dans lequel ledit fil (7) est réalisé soit en cuivre, soit en un matériau contenant du cuivre comme composant principal, tandis que le matériau tubulaire (6b) est réalisé par un alliage de fer-nickel.

0 084 859

## FIG. 1

## FIG. 2

## FIG. 3

1